# EUROPEAN PATENT SPECIFICATION

(11) **EP 2 658 152 B1**
(45) Date of publication and mention of the grant of the patent: **01.03.2017**
(21) Application number: 13165186.1
(22) Date of filing: 24.04.2013
(51) Int. Cl.: H04B 17/00, G01D 18/00

(54) **Flexible evaluation of free space over the air measurement uncertainty method and apparatus**
Flexible Auswertung von Freiraum über Luftmesssicherheitsverfahren und Vorrichtung
Procédé et appareil d'évaluation flexible d'un espace libre sur l'incertitude de mesure d'air

(30) Priority: 26.04.2012 US 201261638916 P
(43) Date of publication of application: 30.10.2013
(73) Proprietor: ZTE (USA) INC., Richardson, TX 75080 (US)
(72) Inventor: Taylor, Carolyn, Homewood, IL Illinois 60430 (US)
(74) Representative: Price, Nigel John King

(56) References cited:
- WO-A1-2007/015682
- JP-A- 2005 024 533
- ANDERSON V: "Estimating uncertainty in calculated ambient RF field levels for hazard assessments", ELECTROMAGNETIC COMPATIBILITY SYMPOSIUM ADELAIDE, 2009, IEEE, PISCATAWAY, NJ, USA, 16 August 2009 (2009-08-16), pages 102-108, XP031577956, ISBN: 978-1-4244-4674-2
- "IEC 62232 Ed.1: Determination of RF fields in the vicinity of mobile communication base stations for the purpose of evaluating human exposure;IEC 62232 Ed.1electromagnetic fields associated106145eCD", ETSI DRAFT; IEC 62232 ED.1ELECTROMAGNETIC FIELDS ASSOCIATED106_145E_CD, EUROPEAN TELECOMMUNICATIONS STANDARDS INSTITUTE (ETSI), 650, ROUTE DES LUCIOLES ; F-06921 SOPHIA-ANTIPOLIS ; FRANCE, vol. Safety, 5 March 2008 (2008-03-05), pages 1-117, XP014102988, [retrieved on 2008-03-05]
- YU JI: "Uncertainty Model for the Dipole-like Antenna Factor Measurements on an Open Area Test Site", MICROWAVE CONFERENCE PROCEEDINGS, 2005. APMC 2005. ASIA-PACIFIC CONFER ENCE PROCEEDINGS SUZHOU, CHINA 04-07 DEC. 2005, PISCATAWAY, NJ, USA,IEEE, vol. 5, 4 December 2005 (2005-12-04), pages 1-4, XP010902490, ISBN: 978-0-7803-9433-9
- "IEEE Recommended Practice for Determining the Peak Spatial-Average Specific Absorption Rate (SAR) in the Human Head From Wireless Communications Devices: Measurement Techniques;IEEE Std 1528-2003 ED - Anonymous", IEEE STANDARD; [IEEE STANDARD], IEEE, PISCATAWAY, NJ, USA, 1 January 2003 (2003-01-01), pages _1-149, XP017603631, ISBN: 978-0-7381-3717-9

## Description

The present invention relates to a computer program, a computer program product and a method for evaluating uncertainty for free space measurements. The field of the present invention is free space measurements, and, in particular, calculating the total measurement uncertainty for laptop mounted plug-in user equipment and laptop embedded user equipment.

Conventional measurement procedures apply to user equipment/mobile station (UE/MS) are used under "speech mode" conditions, that is, predefined positions for voice application when the UE is held close to the user's head. The device under test (DUT) is attached to the SAM phantom
in "cheek" position. The DUT performance may be measured on both the left and right side of the head. An important part of the measurement procedure is the identification of sources of uncertainty and the evaluation of the overall measurement uncertainty.

Various sources of uncertainty introduced in the measurement procedure contribute to the final measurement. A technique for calculating the total measurement uncertainty is based on the ISO Guide for the expression of uncertainty in measurement also known as ISO-GUM. Each value of a source of uncertainty is expressed by its Standard Deviation. The uncertainty contributions can be classified to two categories: Type-A uncertainties, which are statistically determined and Type-B uncertainties, which are derived from existing data. Accordingly, the total measurement uncertainty should contain a list of all the components and specify for each component the method used to determine the values.

The data transfer position that applies when the UE is used away from the user's head (free space configuration without head and hand phantoms) is quite different. A laptop ground plane phantom is used for radiated performance measurements in case of a plug-in DUT like USB dongles. The objective of the laptop ground plane phantom is to reproduce the effects of the ground plane for the antenna of the DUT while avoiding the variation of the measurements introduced by an actual laptop. Neither the laptop ground plane phantom nor the SAM phantom is used with the laptop embedded equipment user equipment UEs.

Although it is possible to use the same technique for calculating the total measurement uncertainty, a problem arises due to the incompatibility of the "speech mode" position when the device is held close to the user's head and data transfer position when the device is used away from the user's head. Hence, despite the development of methods for determining measurement uncertainty, most involve the statistical treatment for uncertainty evaluation of measured values. Furthermore, existing methods do not adequately take uncertainty related to the use of the laptop ground plane phantom or laptop embedded equipment UEs sources of uncertainty into consideration in the evaluation.

Accordingly, a method is desired for calculating the total measurement uncertainty for laptop mounted equipment (LME) and laptop embedded equipment (LEE) UEs. Additionally, a system is desired for testing a radio frequency (RF) device, the RF device having a body and an antenna, and the antenna being configured to propagate an RF signal which is suitable for measurement uncertainty evaluation of LME and LEE UEs.

"Estimating Uncertainty in Calculating Ambient RF Field Levels For Hazard Assessments "by V. Anderson, Electromagnetic Compatibility Symposium Adelaide, 2009, IEEE, 16 August 2009 discloses a process for calculating uncertainty for calculated assessments. The process incorporates a series of validation tests which are used to gauge the uncertainty in the computational technique and round off error.Aspects of the present invention are directed towards determining a total measurement uncertainty for LME and LEE UEs.

JP2005024533 discloses the automation of a measurement and uncertainty evaluation system based on ISO-GUM.

According to the present invention there is provided a method for evaluating uncertainty for free space measurements, a computer program and a computer program product as defined in the claims. In one aspect, a method includes identifying sources of uncertainty associated with at least one quantity subject to measurement. The method also includes representing the at least one quantity subject to measurement as a function of at least one physically observably quantity. The method also includes obtaining a value of the at least one quantity subject to measurement. Based on the obtained values, values of the sources of uncertainty are derived.

### BRIEF DESCRIPTION OF THE DRAWINGS

The present invention will be described by way of example with reference to the accompanying drawings as follows.
Fig. 1 is a flow diagram illustrating a procedure of uncertainty based on ISO-GUM.
Fig. 2 is a flow diagram illustrating a procedure of uncertainty evaluation for free space measurements in the data transfer position according to an embodiment of the present invention.
Fig. 3A illustrates a system implementing a method according to an embodiment of the present invention.
Figs. 3B and 3C are block diagrams of a system according to embodiments of the present invention.
Fig. 3D is a schematic diagram of a budget tabled prepared by a communication system.
Fig. 4 is a flow diagram illustrating the procedure of carrying out free space measurements and uncertainty evaluation according to an embodiment of the present invention.

In a first aspect there is provided a method for determining the total measurement uncertainty measurements in case of plug-in DUT like universal serial bus (USB) dongles and laptop embedded equipment DUT like embedded module cards associated with the value of a free space measurement derived from measurement of a DUT. The method comprises providing a statistical model in which the free space measurement is expressed as (i) the actual measurement of the 3-D pattern of the device under test (DUT), and (ii) the calibration of the absolute level of the DUT measurement results are performed by means of using a calibration antenna whose absolute gain/radiation efficiency is known at the frequencies of interest. Uncertainty values are then determined from the DUT measurement using the provided statistical model. The statistical model is formulated to take into account the uncertainty related to the use of the laptop ground plane phantom or the laptop embedded equipment UEs.

In other words, the method for calculating the total measurement uncertainty for LME and LEE UEs is based on the uncertainty evaluation method proposed by the International Organization for Standardization (ISO) in the Guide to the expression of Uncertainty in Measurement (ISO-GUM). In theory, the method comprises a first step of modeling the measurement with a view to establishing mathematically the relationship between the particular quantity subject to measurement and all sources of uncertainties which may contribute to the uncertainty associated with the measurement. In the second step, measurement values of the particular quantity subject to measurement and values regarding each source of uncertainty which contribute to the combined uncertainty are obtained. In the third step numerical and statistical analysis is carried out to evaluate uncertainty of the particular quantity subject to measurement following the ISO-GUM procedure.

In another aspect, this invention relates to a system for free space measurement and evaluation of associated uncertainty for the laptop ground plane phantom or the laptop embedded equipment UEs. The system consists of a transmitter and receiver for data transfer, a system for testing a radio frequency (RF) device, the RF device having a body and an antenna, and the antenna being configured to propagate an RF signal which is suitable for measurement uncertainty evaluation of LME and LEE UEs.

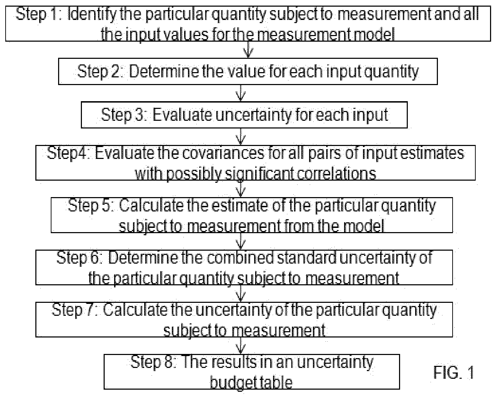

FIG. 1 shows the procedure of calculating uncertainty according to ISO-GUM. The procedure of uncertainty in relation to ISO-GUM consists of 8 steps. The initial step 1 identifies the particular quantity subject to measurement and all the input values for the measurement model. In step 2, an estimate value for each input quantity is determined. Uncertainty for each input is evaluated in step 3. Step 4 consist of the evaluating covariances for all pairs of input estimates with possibly significant correlations. Calculation of the estimate of the particular quantity subject to measurement from the model occurs in step 5. In step 6, combined uncertainty for the particular quantity subject to measurement is determined. In step 7, the uncertainty of the particular quantity subject to measurement is calculated. In Step 8, the uncertainty budget table is provided.

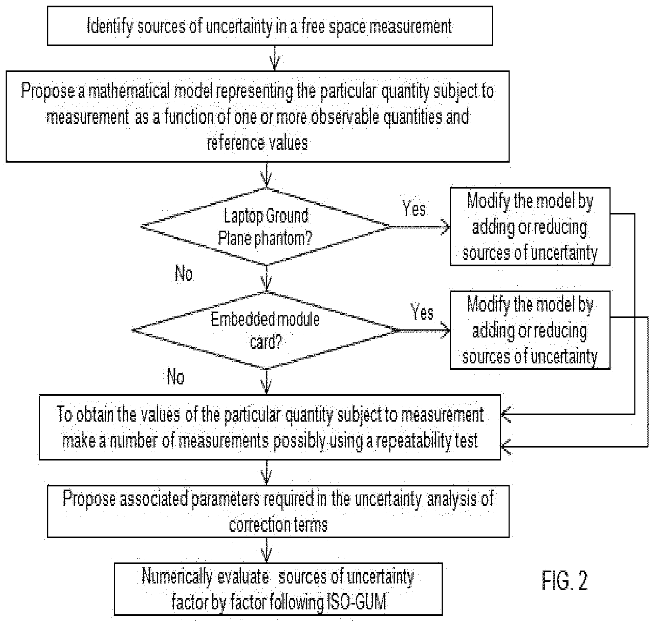

FIG. 2 is a flow diagram showing the procedure of uncertainty evaluation for free space measurements in the data transfer position according to an embodiment of the present invention. First, all the sources of uncertainty in a free space measurement are proposed. Next, all the components associated with these sources of uncertainties, including correction terms, are incorporated into a mathematical model which represents the particular quantity that is the subject of the measurement as a function of at least one physically observable quantity and reference value of a reference DUT. One can estimate this with a repeatability test by making a series of repeated measurements with a reference DUT without changing anything in the measurement system. As a result, the mathematical model is composed of directly measured values that are statistically determined, and indirectly measured values that are derived from existing data and modifications.

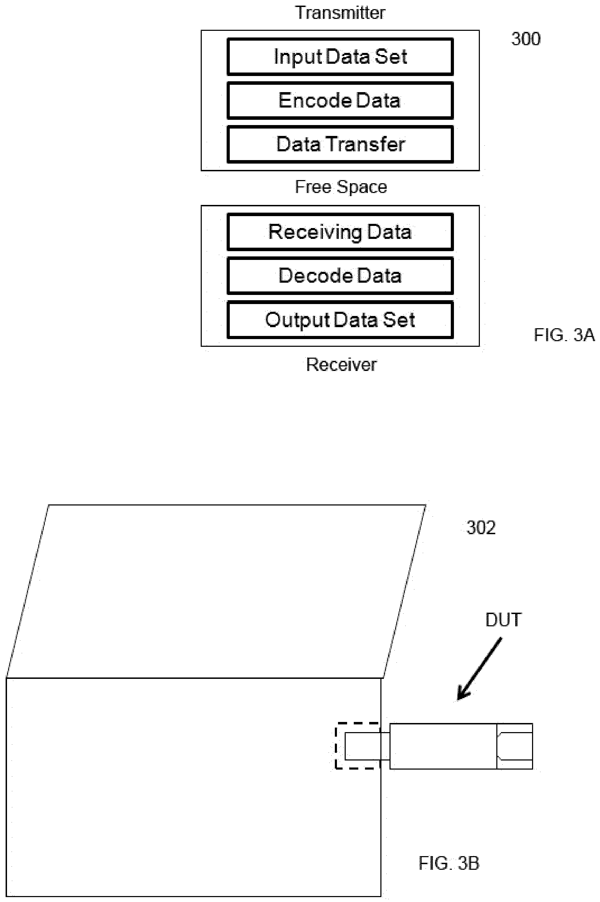

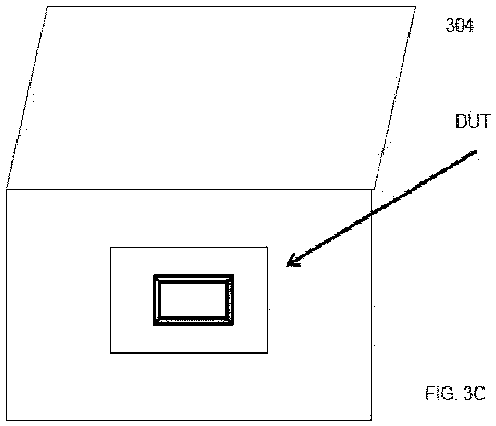

FIG. 3A illustrates a communication system including a transmitter and receiver for data transfer, a system for testing a radio frequency (RF) device, the RF device having a body and an antenna, and the antenna being configured to propagate an RF signal which is suitable for measurement uncertainty evaluation of LME and LEE UEs.

Turning now to FIGS. 3B-3C, a method according to an embodiment of the present invention will be described in terms of a number of steps to be taken for free space measurements in the data transfer position (free space) such as the system described above in connection with FIG. 3A.

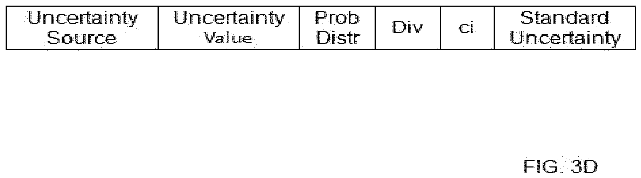

FIG. 3D shows an example of an uncertainty budget table for DUT measurement variables. The observable variables/parameters representing each selected source are taken into account in the model for the evaluation of uncertainty and statistically analyzed. It consists of an uncertainty source, an uncertainty value, a probability distribution, div, ci and standard uncertainty.

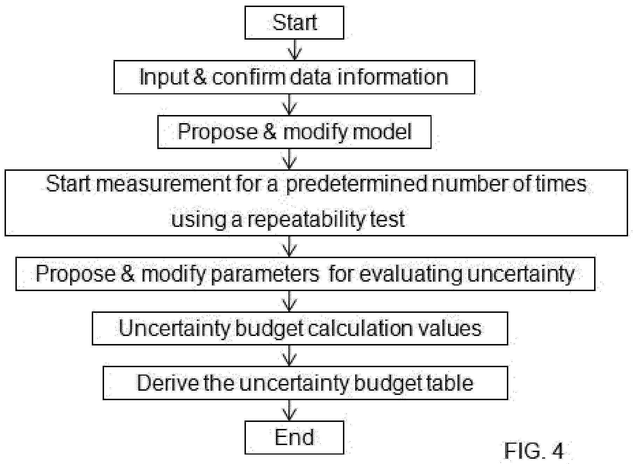

FIG. 4 illustrates the procedure of carrying out free space measurements and uncertainty evaluation in relation to the system according to embodiments of the present invention. When the system is ready for operation, the information is provided to continue to the next step. For different particular quantities subject to measurement, there are different mathematical models. However, the use of the other type of model is also allowed when the resulting uncertainty contribution is taken into account in the uncertainty budget. The free space measurement in the data transfer position system may be controlled to take appropriate way of measurement by reducing factors of uncertainty.

It should be understood that the methods and systems of the present invention are executed employing machines and apparatus including simple and complex computers. Moreover, the architecture and methods described above can be stored, in part or in full, on forms of machine-readable media. For example, the operations of the present invention could be stored on machine-readable media, such as magnetic disks or optical disks, which are accessible via a disk drive (or computer-readable medium drive). Alternatively, the logic to perform the operations as discussed above, could be implemented in additional computer and/or machine readable media, such as discrete hardware components as large-scale integrated circuits (LSI's), application-specific integrated circuits (ASIC's), firmware such as electrically erasable programmable read-only only memory (EEPROM's); and the like. Implementations of certain embodiments may further take the form of machine-implemented, including web-implemented, computer software.

While aspects of this invention have been shown and described, it will be apparent to those skilled in the art that many more modifications are possible without departing from the inventive concepts that are described herein. The invention, therefore, is not to be restricted except by the scope of the following claims.

## Claims

1. A method for evaluating uncertainty for free space measurements of a radio frequency, RF, device under test (DUT) comprising laptop mounted equipment (302), the method comprising:
obtaining values of at least one quantity subject to free space measurement expressed as (i) an actual measurement of the 3-D pattern of the device under test and (ii) a calibration of the absolute level of the device under test measurement results,
wherein the obtaining comprises performing a measurement of the at least one physically observable quantity and performing a calibration of the measurement of the at least one physically observable quantity by means of using a calibration antenna whose absolute gain/radiation efficiency is known at frequencies of interest; and
applying a statistical model to the obtained values to derive values of sources of uncertainty associated with the at least one quantity subject to free space measurement,
wherein components associated with the sources of uncertainty are incorporated into the statistical model, and wherein the statistical model is formulated to take into account uncertainty related to use of a laptop ground plane phantom or a laptop embedded equipment UEs.

2. The method of claim 1, wherein the obtaining comprises making at least one measurement of the at least one physically observable quantity using a repeatability test.

3. The method of claim 1 or claim 2, wherein the RF device under test (DUT) comprises laptop embedded equipment (304).

4. The method of claim 1 or claim 2, wherein the RF device under test (DUT) comprises:
an antenna configured to propagate an RF signal.

5. A computer program comprising program code means for performing all the steps of any one of claims 1 to 5 when said program is run on a computer.

6. A computer program product comprising program code means stored on a computer readable medium for performing the method of any one of claims 1 to 5 when said program product is run on a computer.

## Patentansprüche

1. Verfahren zum Bestimmen einer Unsicherheit für Freiraummessungen eines Funkfrequenz-, RF, Prüflings (DUT) umfassend eine Laptop-befestigte-Einrichtung (302), wobei das Verfahren umfasst:
Gewinnen von Werten von mindestens einer Größe, welche Gegenstand einer Freiraummessung ist, ausgedrückt als (i) eine tatsächliche Messung der 3-D-Form des Prüflings und (ii) eine Kalibrierung des absoluten Pegels der Prüflingsmessergebnisse,
wobei das Gewinnen ein Ausführen einer Messung von der mindestens einen physikalisch beobachtbaren Größe und ein Ausführen einer Kalibrierung der Messung von der mindestens einen physikalisch beobachtbaren Größe mittels einer Verwendung einer Kalibrierungsantenne, deren absoluter Gewinn/absolute Strahlungseffizienz bei interessierenden Frequenzen bekannt ist, umfasst; und
Anwenden eines statistischen Modells auf die gewonnenen Werte, um Werte von Quellen einer Unsicherheit abzuleiten, welche der mindestens einen Größe, welche Gegenstand der Freiraummessung ist, zugeordnet ist,
wobei Komponenten, welche den Quellen der Unsicherheit zugeordnet sind, in das statistische Modell eingearbeitet sind, und wobei das statistische Modell formuliert ist, eine Unsicherheit zu berücksichtigen, welche auf eine Verwendung eines Laptop-Grundebenenphantoms oder eines Laptopeingebetteten Einrichtungs-UEs bezogen ist.

2. Verfahren nach Anspruch 1, wobei das Gewinnen ein Durchführen von zumindest einer Messung von der mindestens einen physikalisch beobachtbaren Größe unter Verwendung eines wiederholbaren Tests umfasst.

3. Verfahren nach Anspruch 1 oder Anspruch 2, wobei der RF-Prüfling (DUT) eine Laptop-eingebettete Vorrichtung (304) umfasst.

4. Verfahren nach Anspruch 1 oder Anspruch 2, wobei der RF-Prüfling (DUT) umfasst:
eine Antenne, welche ausgestaltet ist, ein RF-Signal zu übertragen.

5. Computerprogramm, umfassend Programmcodemittel zum Ausführen aller Schritte nach einem der Ansprüche 1 bis 5, wenn das Programm auf einem Computer ausgeführt wird.

6. Computerprogrammprodukt, umfassend Programmcodemittel, welche auf einem computerlesbaren Medium gespeichert sind, zum Ausführen des Verfahrens nach einem der Ansprüche 1 bis 5, wenn das Programmprodukt auf einem Computer ausgeführt wird.

## Revendications

1. Procédé d'évaluation de l'incertitude des mesures d'espace libre d'un dispositif de radiofréquence (RF) sous essai (DUT), comprenant un équipement monté sur ordinateur portable (302), le procédé comprenant les étapes suivantes :
obtenir des valeurs d'au moins une quantité soumise à une mesure d'espace libre exprimée (i) en tant que mesure réelle du motif 3D du dispositif sous essai et (ii) en tant qu'étalonnage du niveau absolu des résultats de mesure du dispositif sous essai,
dans lequel l'obtention comprend la réalisation d'une mesure de la quantité physiquement observable au nombre d'au moins une et la réalisation d'un étalonnage de la mesure de ladite au moins une quantité physiquement observable à l'aide d'une antenne d'étalonnage dont le rendement gain absolu/rayonnement est connu pour des fréquences d'intérêt ; et
appliquer un modèle statistique aux valeurs obtenues pour obtenir des valeurs de sources d'incertitude associées à ladite au moins une quantité soumise à une mesure d'espace libre,
dans lequel des composantes associées aux sources d'incertitude sont incorporées dans le modèle statistique, et dans lequel le modèle statistique est formulé pour prendre en compte l'incertitude liée à l'utilisation d'un fantôme de plan de masse d'ordinateur portable ou d'équipements d'utilisateur incorporés dans un ordinateur portable.

2. Procédé selon la revendication 1, dans lequel l'obtention comprend la réalisation d'au moins une mesure de ladite au moins une quantité physiquement observable en utilisant un test de répétabilité.

3. Procédé selon la revendication 1 ou 2, dans lequel le dispositif RF sous essai (DUT) comprend un équipement (304) incorporé dans un ordinateur portable.

4. Procédé selon la revendication 1 ou 2, dans lequel le dispositif RF sous essai (DUT) comprend :
une antenne configurée pour propager un signal de radiofréquence.

5. Programme informatique comprenant un moyen formant code de programme pour exécuter toutes les étapes de l'une quelconque des revendications 1 à 5 quand ledit programme est exécuté sur un ordinateur.

6. Produit de programme informatique comprend un moyen formant code de programme stocké sur un support lisible par un ordinateur pour exécuter le procédé de l'une quelconque des revendications 1 à 5 quand ledit produit de programme est exécuté sur un ordinateur.
